**Europäisches Patentamt**

**European Patent Office**

**Office européen des brevets**

(19)

(11) Publication number: **0 118 096**

**A2**

(12) # EUROPEAN PATENT APPLICATION

(21) Application number: **84102078.7**

(22) Date of filing: **28.02.84**

(51) Int. Cl.³: **G 03 F 7/26**

(30) Priority: **28.02.83 JP 32148/83**

(43) Date of publication of application:
**12.09.84 Bulletin 84/37**

(84) Designated Contracting States:
**DE GB**

(71) Applicant: **FUJI PHOTO FILM CO., LTD.**
**210 Nakanuma Minami Ashigara-shi**
**Kanagawa 250-01(JP)**

(72) Inventor: **Shiba, Keisuke c/o Fuji Photo Film Co., Ltd.**
**No. 210, Nakanuma**
**Minami Ashigara-shi Kanagawa(JP)**

(72) Inventor: **Koizumi, Shigeo c/o Fuji Photo Film Co., Ltd.**
**No. 4000, Kawajiri Yoshida-cho**
**Haibara-gun Shizuoka(JP)**

(74) Representative: **Barz, Peter, Dr. et al,**
**Patentanwälte Dr. V. Schmied-Kowarzik Dipl.-Ing. G.**
**Dannenberg Dr. P. Weinhold Dr. D. Gudel Dipl.-Ing. S.**
**Schubert Dr. P. Barz Siegfriedstrasse 8**
**D-8000 München 40(DE)**

(54) **Enzyme-containing liquid processing agent used in treatment of light-sensitive lithographic printing plates and plate-making method.**

(57) An enzyme-containing liquid processing agent used in treatment of light-sensitive lithographic printing plates and a plate-making method using this processing agent are described. This processing agent is comprised of a hydrolase and an inorganic salt selected from halides, sulphates, sulfites, hyposulfites, thiocyanates, borates, and phosphates, and has a pH adjusted to from 3 to 8.5. The hydrolase includes carbohydrase amydase, and protease. This processing agent is greatly improved in storage stability; that is, the activity of the hydrolase is maintained over long periods of time, such as at least 6 months. Since the processing agent has both a fixing and film-removing action on account of the presence of the inorganic salt, it can be used in a plate-making method utilizing an automatic developing machine.

EP 0 118 096 A2

## ENZYME-CONTAINING LIQUID PROCESSING AGENT
## USED IN TREATMENT OF LIGHT-SENSITIVE LITHOGRAPHIC
## PRINTING PLATES AND PLATE-MAKING METHOD

The present invention relates to an enzyme-containing liquid processing agent which is greatly improved in stability over time and can be used directly or after dilution. More particularly the present invention relates to an enzyme-containing liquid processing agent for use in treatment of a light-sensitive lithographic printing plate comprising a support having a hydrophilic surface and at least a silver halide emulsion layer on the support and further to a plate-making method using the enzyme-containing liquid processing agent.

Of enzymes such as hydrolase, oxido-reductase, coagulase, or synthetic enzymes, hydrolase (e.g., carbohydrase, amidase and protease), in particular, are commercially supplied mainly in the form of powder and applied in the form of a solution in use. Hydrolase is used in, for example, the leather-manufacturing industry, fiber industry, and dye industry, and partly as a medicine. In the photographic industry, protease, for example, is used in the recovery of silver.

Even in the print industry, as described in,

- 1 -

for example, Japanese Patent Application (OPI) No. 25739/81, (corresponding to U.S. Patent 4,299,912), enzymes are used in the process of production of lithographic printing plates. The term "OPI" as used herein means a "published unexamined Japanese patent application".

Enzymes (excluding synthetic enzymes) are produced by living cells. The thus-produced crude enzymes are extracted and purified. From an industrial standpoint, it is considered advantageous to use them in the form of a solution as obtained in the extraction/purification process without converting them into a powder form. In practice, however, the enzymes are used in the form of powder since their active components have poor storage stability. Further the amount of the active component and its activity can vary. All the enzymes can be said to be proteins or proteins with specific low molecular compounds bonded thereto. Hence the inherent function and effect of the enzymes are readily deteriorated. Therefore, when making industrial use of the enzymes special techniques should be deviced to avoid their deactivation and variation.

In the uses as described above, particularly with the plate-making treatment in the photographic industry, it has been a significant subject to develop an enzyme-containing processing agent in which the activity of the enzyme can be held over long periods of time so that

- 2 -

the enzyme can be supplied automatically to achieve the automatization of the treatment.

However, no investigation has been made to improve the storage stability of enzymes contained in such liquid processing agents.

An object of the invention is to provide an enzyme-containing liquid processing agent in which the activity of the enzyme can be maintained for a long period of time, preferably at least 6 months and more preferably at least one year.

Another object of the invention is to provide an enzyme-containing liquid processing agent which can be used in the plate-making method as described in, for example, Japanese Patent Application (OPI) No. 25739/81, and which has both a silver halide-fixing action and a film-dissolving action.

Still another object of the invention is to provide an automatic replenishment type plate-making system utilizing the enzyme-containing processing agent as described above.

Other objects of the invention will become apparent from the detailed description as described hereinafter.

It has been found that the objects can be attained by adding specific inorganic salts to an enzyme-containing liquid processing agent and adjusting its pH to 3 to 8.5.

The present invention relates to an enzyme-containing liquid processing agent characterized in that it contains an inorganic salt and the pH is adjusted to 3 to 8.5.

One of the features of the invention is that the storage stability of enzymes in the form of aqueous solutions are improved. Thus the effect of the invention is markedly exhibited in liquid processing agents containing hydrolases which are very inferior in storage stability.

The liquid processing agent of the present invention has a pH adjusted to form 3 to 8.5, and includes hydrolase and at least one inorganic salt. The liquid processing agent may be used for processing a light sensitive lithographic printing plate, by carrying out imagewise exposure, development, enzyme/fix treatment, light exposure, removal of the emulsion layer and development of non-silver light-sensitive layer.

The light-sensitive lithographic printing plate used in connection with the present invention comprises a support having a hydrophilic surface, and a non-silver light-sensitive layer capable of forming an oleophilic image, and a gelatin silver halide emulsion layer in this sequence on the support.

Hydrolases used in the present invention include:

(1) carbohydrases, such as polysaccharase acting on polysaccharide, disatase, cellulase, inulase, pectinase, and lichenase, all acting on the polysaccharide; glucosidase and celloviase, acting on the alucocide bond; and galactosidase acting on the galactoside group;

(2) amidases acting on compounds containing an amido group or its derivatives, such as urease, acid amidase, alginase, and aminoacidase;

(3) esterases which act so as to decompose ester compounds, such as lipase, lecidase, cholesterase, phosphatase, and sulfatase; and

(4) proteases acting on proteins or their hydrolyzates.

These hydrolases are sufficiently soluble in water, and they are used in a concentration of from 0.001 to 10% by weight and preferably from 0.1 to 5% by weight, based on the weight of the prepared liquid processing agent.

Inorganic salts which can be used in the present invention are preferably water-soluble inorganic salts selected from halides, sulfates, sulfites, hyposulfites, thiocyanates, nitrates, nitrites, phosphates, borates or their similar salts. Of inorganic salts, salts of acids derived from sulfur oxides and bases, thiocyanates, phosphates and borates are more preferable. Cations can be preferably selected from Groups I and II metal ions such as sodium ion, potassium ion, lithium ion, etc., ammonium, and onium ions.

These inorganic salts can be used singly or as a mixture comprising two or more thereof. It is suitable for the inorganic salt to be added in such an amount that the concentration of the inorganic salt in the final enzyme-containing liquid processing agent is at least 1 mole, preferably from 1 to 5 moles, and more preferably from 1 to 3 moles per liter of the liquid processing agent.

The enzyme-containing liquid processing agent of the present invention is adjusted to from 3 to 8.5 and preferably from 3 to 7.5 in pH. In this pH adjustment, commonly used pH buffers such as acetic acid, acetates, hydrochloric acid, potassium chloride, acidic potassium phthalate, phosphoric acid, boric acid, borates, glycine, and sodium veronal can be used appropriately in combination with each other.

Even in the case of hydrolases, if the inorganic salt as described above is added in a concentration of at least 1 mole per liter of the solution and the pH is adjusted to the specific range as described above, their storage stability is greatly improved.

Another feature of the invention is that if, of the inorganic salts as described above, salts of sulfur oxides such as hyposulfide, sulfite, and sulfate and bases,

- 6 -

thiocyanates, phosphates, borates, and so on are added so that the concentration in the final enzyme-containing liquid processing agent is at least 1 mole per liter of the liquid processing agent, the deactivation and variation of enzymes are greatly improved and the putrefaction (hydrolysis) of the enzymes themselves is greatly inhibited, i.e., the storage stability of enzymes is greatly improved, as compared with cases in which the other inorganic salts are added in the same concentration. The addition of the specific inorganic salts as described above further produces the advantages that the enzyme solution is prevented from becoming opaque with a lapse of time, i.e., turbidity is inhibited, and precipitation and discoloration are inhibited.

Another feature of the invention is that of the inorganic salts as used herein, hyposulfite, sulfite, thiocyanate, phosphates, and borates which are used in the developing and fixing processes of a silver halide emulsion layer can be used advantageously particularly in improving the storage stability of an aqueous solution of protease.

The optimum light-sensitive lithographic printing plate and its plate-making method as used in the invention are described in detail, for example, in U.S. Patents, 4,268,609 and 4,299,912, both of which are incorporated by reference. In accordance with this plate-making method, a printing plate is produced by a

- 7 -

process comprising imagewise exposure, first-development of silver halide emulsion layer, fixation, exposure to light, removal of exposed silver halide emulsion layer, second-development of non-silver light-sensitive layer, and treatment of the surface. This series of plate-making treatments are usually performed by means of an automatic developing machine. If the enzyme-containing liquid processing agent of the invention is used in this plate-making method, the fixation and removal of exposed silver halide emulsion layer among the plate-making treatments as described above can be performed simultaneously and automatically in the automatic developing machine during the light exposure step. Furthermore, since the enzyme-containing liquid processing agent of the invention has good storage stability, it can also be used as a replenishing liquid.

Hence the present invention yields various advantages; for example, the time required for plate-making can be shortened, the automatic developing machine can be miniaturized and simplified, the plate-making operation can be rationalized since the processing solution can be automatically replenished, and thus the plate-making cost can be reduced.

Proteases for use in the enzyme-containing processing agent as used in the plate-making method of the present invention include ficin, papain, pepsin, and trypsin.

Commercially available proteases such as Takaminc HT (trade name, produced by Miles Laboratories), Bioplase PN-4 (trade name, produced by Nagase Seikagaku Kogyo Co., Ltd.), Pronase P (trade name, produced by Kaken Kagaku Co., Ltd.), and Miyapron AF (trade name, produced by Teikoku Kōso Co., Ltd.) can be used. In addition, the proteases as described in, for example, Japanese Patent Publication No. 36205/70, Japanese Patent Application (OPI) No. 97738/77, Research Disclosure, 15025, British Patents 1,179,769, 1,354,186, U.S. Patents 3,515,551, 3,565,618, 3,620,737, and 3,832,178 can be used.

The present invention is described in greater detail with reference to the following examples, although it is not limited thereto. All percents are by weight.

<div align="center">EXAMPLE 1</div>

Composition A

| | |
|---|---|
| Water | 700 mℓ |
| Ammonium thiosulfate | 150 g |
| Sodium sulfite | 20 g |
| Acetic acid (90%) | 30 mℓ |
| Miyapron AF (produced by Teikoku Koso Co., Ltd.) | 20 g |
| Water to make | 1,000 mℓ |

Composition B

| | |
|---|---|
| Water | 600 mℓ |

| Sodium thiosulfate | 360 g |
| Ammonium chloride | 50 g |
| Anhydrous sodium sulfite | 15 g |
| Acetic acid (28%) | 48 mℓ |
| Boric acid | 7.5 g |
| Bioplase PN-4 (produced by Nagase Seikagaku Kogyo Co., Ltd.) | 20 g |
| Water to make | 1,000 mℓ |

Composition C

| Water | 500 mℓ |
| Ammonium thiosulfate (70% aqueous solution) | 369.2 mℓ |
| Sodium thiosulfate | 46 g |
| Sodium sulfite | 30.4 g |
| Boric acid | 14.2 g |
| Ammonia water (28%) | 12.5 mℓ |
| Acetic acid (90%) | 31.5 mℓ |
| Miyapron AF (produced by Teikoku Koso Co., Ltd.) | 20 g |
| Water to make | 1,000 mℓ |

For comparison, the following Composition D was prepared.

Composition D (Control Composition)

| Miyapron AF (produced by Teikoku Koso Co., Ltd.) | 20 g |
| Water | 1,000 mℓ |

Each composition (10 ℓ) was placed in a tank made of a vinyl chloride resin and stored at room temperature (25 ± 5°C) for 6 months in the condition that air was flowing thereover.

A 2S aluminum plate which had been mechanically grained was soaked in a 2% aqueous solution of sodium hydroxide maintained at 40°C for 1 minute to corrode part of the surface thereof. After washing with water, the aluminum plate was soaked in a sulfuric acid/chromic acid solution for about 1 minute to expose the surface of pure aluminum. The plate was then soaked in 20% sulfuric acid maintained at 30°C and anodized for 2 minutes under the conditions of D.C. voltage 1.5 V and current density 3 $A/dm^2$. Thereafter it was washed with water and dried.

The thus-treated aluminum plate was continuosly coated with a light-sensitive solution having the formulation as described hereinafter by means of an extrusion type coating head so that the amount of the solution coated (dry basis) was about 2 $g/m^2$.

Light-Sensitive Solution

Naphthoquinone-1,2-diazido-(2)-5-sulfonic acid ester of acetone/pyrogallol resin (prepared by the method described in Example 1 of U.S. patent 3,635,709)            2.5 g

- 11 -

| Cresol-formaldehyde resin | 5.0 g |
| Methyl ethyl ketone | 75 g |
| Cyclohexanone | 60 g |

A silver halide light-sensitive emulsion having the formulation as described hereinafter was coated continuously and uniformly by means of an extrusion type coating head so that the amount of the emulsion coated (dry basis) was 4.0 g/m$^2$, and dried with hot air at 80°C for 3 minutes to form a lithographic printing material. This material was then subjected to the following plate-making processing.

Emulsion prepared by dissolving 25 g of a phenolformaldehyde resin MP-120HH (produced by Gunei Kagaku Kogyo Co., Ltd.) and 25 g of dioctyl adipate in a mixed solvent of 330 g of ethyl acetate and 120 g of methyl ethyl ketone and then dispersing the resulting solution in a mixed solution of 600 ml of a 10% aqueous solution of gelatin, 60 ml of a 10% solution of sodium nonylbenzenesulfonate, and 150 ml of a 10% methanol solution of Turkey red oil. ... 1,300 g

Silver chlorobromide/gelatin emulsion ($C\ell^-$: 70 mole%, $Br^-$: 30 mole%; mean grain diameter: 0.28 μ; amount of gelatin per kg of emulsion: 55 g; silver halide content: 0.85 mole) ... 2,000 g

0.1% Methanol solution of sodium 1,3-diethyl-5-[2-{3-(3-sulfopropyl)benzoxazole-2-ylidene}ethylidene] thiohydantoin ... 100 ml

- 12 -

0.5% Aqueous solution of 4-hydroxy-6-methyl-1,3,3a,

7-tetrazaindene                                   200 ml

1% Aqueous solution of glyoxal        ...  20 ml

A letter original image reduced in size to about 1/5 was projected to form a transparent negative film. The material as prepared above was exposed to light through the transparent negative film for 10 seconds at an enlargement ratio of 5 by means of an extender equipped with a 300 lux light source.

The thus-exposed material was processed using an automatic developing machine as follows:

The material was passed through a first developing zone filled with Developer (I) having the formulation as described hereinafter at 32°C over 30 seconds, and then through an enzyme-treating and fixing zone filled with an enzyme-containing processing agent (each of Compositions A to C as described above) at room temperature over 10 seconds. Subsequently the material was passed through an ultraviolet exposing zone provided with 3 reflection type mercury lamps over 15 seconds, rinsed with hot water maintained at 40-45°C, and then passed through a squeeze roll and a second developing zone filled with Developer (II) having the formulation as described hereinafter at 30°C over 30 seconds. A gum solution FP (produced by Fuji Photo Film Co., Ltd.) was then coated to form a printing plate.

Developer (I)

| | |
|---|---|
| Water | 700 mℓ |
| Metol | 3.0 g |
| Sodium sulfite | 45.0 g |
| Hydroquinone | 12.0 g |
| Sodium carbonate (monohydrate) | 80.0 g |
| Potassium bromide | 2 g |
| Water to make | 1,000 mℓ |

In use one volume of this developer is diluted with 2 volumes of water.

Developer (II)

| | |
|---|---|
| Sodium silicate (JIS No. 1) | 100 g |
| Sodium metasilicate | 50 g |
| Pure water | 1,800 mℓ |

Using an enzyme-containing liquid processing agent of Composition D (control composition), the following treatment was carried out by means of the same automatic developing machine as described above.

The same lithographic printing material as above was exposed to the same amount of light as described above, passed through a first developing zone filled with Developer (I) at 32°C over 30 seconds and then through a fixing zone filled with Fixing Solution (I) as described hereinafter at room temperature over 10 seconds. Subsequently it was passed through an ultraviolet exposing zone provided with 3 reflec-

- 14 -

tion type mercury lamps over 15 seconds. The material was then soaked in a washing zone filled with the enzyme-containing processing solution of Composition D maintained at 40-45°C and brushed in the state that it was soaked therein, passed through a squeeze roll, and developed with Developer (II). A gum solution FP was coated to form a printing plate.

Fixing Solution (I)

| | |
|---|---|
| Water | 700 m$\ell$ |
| Ammonium thiosulfate | 150 g |
| Sodium sulfite | 20 g |
| Acetic acid (90%) | 3.0 m$\ell$ |
| Water to make | 1,000 m$\ell$ |

In the plate-making processing as described above, Compositions A to D were each used in two manners, i.e., after being stored at room temperature for 6 months and as a fresh solution prepared on the day when it was used. Thus 8 printing plates were produced.

Each printing plate was mounted on a Heidel KOR printing machine and used for printing. The results are shown in Table 1.

Table 1

| Enzyme-Containing Processing Solution | Number of Waste Sheets before Printing | Quality of Printed Image |
|---|---|---|
| Fresh Solution | | |
| Composition A | 5 | good |
| " B | 5 | good |
| " C | 5 | good |
| " D | 5 | good |
| Solution Stored For 6 Months | | |
| Composition A | 5 | good |
| " B | 5 | good |
| " C | 5 | good |
| " D | 210 | Spots with no ink printed and print unevenness are formed. |

Compositions A to C showed the same processing performance in both cases, i.e., after being stored for 6 months and as a fresh processing solution. In the case of Composition D, however, its ability to decompose and remove the emulsion layer composed mainly of gelatin was almost lost over time.

CLAIMS:

1.          An enzyme-containing liquid processing agent, used in the treatment of light-sensitive lithographic printing plates, containing a hydrolase and an inorganic salt, and being adjusted to a pH of from 3 to 8.5.

2.          An enzyme-containing liquid processing agent as claimed in Claim 1, wherein the hydrolase is selected from carbohydrases, amydases, esterases and proteases.

3.          An enzyme-containing liquid processing agent as claimed in Claim 1 or 2, wherein the inorganic salt is selected from halides, sulfates, sulfites, hyposulfite, thiocyanates, nitrates, nitrites, phosphates and borates.

4.          An enzyme-containing liquid processing agent as claimed in any of Claims 1-3, wherein the hydrolase is contained in a concentration from 0.001 to 10% by weight based on the weight of the liquid processing agent.

5.          An enzyme-containing liquid processing agent as claimed in any of Claims 1-4, wherein the inorganic salt is contained in a concentration of at least 1 mole per liter of the liquid processing agent.

6.          An enzyme-containing liquid processing agent as claimed in Claim 5, wherein the inorganic salt is contained in a concentration of from 1 to 5 moles per liter of the liquid processing agent.

7.          A plate-making method comprising imagewise exposing a light-sensitive lithographic printing plate comprised of a support having a hydrophilic surface, a non-silver light-sensitive layer forming oleophilic images and a gelatin-silver halide emulsion layer, developing the silver halide, subjecting the plate to enzyme/fix
treatment, light exposing the plate, removing the emulsion
layer and developing the non-silver light-sensitive layer.